# EUROPÄISCHE PATENTSCHRIFT

(11) **EP 2 315 325 B1**
(45) Veröffentlichungstag und Bekanntmachung des Hinweises auf die Patenterteilung: **11.01.2017**
(21) Anmeldenummer: 10187265.3
(22) Anmeldetag: 12.10.2010
(51) Int. Cl.: H02B 1/052, H05K 7/20, H05K 5/04

(54) **Winkelprofil und aus Winkelprofilen hergestelltes Kastenprofil sowie System aus Kastenprofilen**
Angle profile and box profile comprising angle profiles and system of box profiles
Profilé d'angle et profilé de caisse fabriqué à partir de profilés d'angle ainsi que système constitué de profilés de caisse

(30) Priorität: 13.10.2009 DE 102009045626
(43) Veröffentlichungstag der Anmeldung: 27.04.2011
(73) Patentinhaber: DResearch Digital Media Systems GmbH, 10319 Berlin (DE)
(72) Erfinder: Weber, Dr. Michael, 12683, Berlin (DE)
(74) Vertreter: Gulde & Partner

(56) Entgegenhaltungen:
- EP-A1- 0 382 141
- DE-U1- 8 711 521
- DE-U1- 9 318 474
- DE-U1-202006 006 133
- FR-A1- 2 312 917
- FR-A1- 2 345 837
- FR-A1- 2 598 585
- FR-A1- 2 612 727

## Beschreibung

Die vorliegende Erfindung betrifft ein Kastenprofil, und ein System aus miteinander verbundenen Kastenprofilen.

Es ist bekannt, Gehäuse für die Aufnahme von Leiterkarten und/oder weiteren elektronischen und elektrischen Komponenten sowohl aus Kunststoff als auch aus Metall herzustellen. Dabei sind die vielfältigsten Ausbildungen derartiger Gehäuse bekannt. Ein Grundprinzip dieser Gehäuse ist, dass sie aus mehreren Einzelteilen bestehen, die zur Bildung des Gehäuses beispielsweise durch Schraub- oder Schweißverbindungen zusammengehalten werden. Wird eine Reduzierung der Einzelteile des Gehäuses vorgenommen, so kommen zur Bildung des Gehäuses, wie aus der DE 102 19 972 A1 hervorgeht, verschraubte Schalengehäuse aus Blechbiegeteilen, sowie mehrteilige Gussgehäuse, aber auch mehrteilige Steckgehäuse aus Kunststoff zur Anwendung.

Nachteilig bei diesen Gehäusen ist, dass sie bei Metallausführung meistens als Blechbiegeteil-Schraubkonstruktion ausgeführt sind, so dass die Montage sehr aufwendig und daher relativ kostenintensiv ist. Ein weiterer Nachteil ist aber auch, dass unabhängig vom zur Anwendung kommenden Material die Schraubenverbindungen an den Seiten sowie am Boden oder am Deckel sichtbar sind und daher oft störend wirken.

Unter Berücksichtigung der Vielzahl weiterer bekannter Gehäuse wird beispielsweise bei einem Gehäuse zur Aufnahme elektrischer und elektronischer Einbauten gemäß der DE 100 07 490 A1 von zwei zueinander parallel angeordneten, plattenförmigen Abdeckungen ausgegangen. Diese sind mittels vertikal zu den Abdeckungsebenen verlaufenden Profilschenkeln miteinander verbunden, wobei die beiden, der Gehäuse-Frontseite zugewandten Profilschenkel eine Innenfläche aufweisen, die vertikal zur Gehäusevorderseite angeordnet ist. Die Herstellung dieses Gehäuses ist jedoch ausgehend von der Vielzahl der zur Komplettierung des Gehäuses erforderlichen Einzelteile, insbesondere aber auch unter Berücksichtigung der benötigten Zeit zu seiner Montage, unverhältnismäßig aufwendig und somit ebenfalls mit relativ hohen Herstellungskosten verbunden.

Diese Nachteile werden auch durch ein ebenfalls bekanntes Gehäuse nach der DE 101 00 989 A1 nicht vermieden, bei dem auf eine Trägerplatte von Gehäusewänden elektromechanische und elektronische Komponenten montiert werden und bei dem neben den Gehäusewänden ausgehend von Metall als Material auch ein Deckel sowie Vorder- und Rückwände vorgesehen sind. Dabei ist an den Übergängen von der Trägerplatte zu den Seiten und von der Rückseite zum Deckel das Metallblech biegefähig, so dass die Gehäusewände später zusammengeklappt werden können. Um das Zusammenklappen zu ermöglichen, sind bei diesem Gehäuse Kunststoffscharniere vorgesehen. Während auf den Gehäusewänden aus Kunststoff bestehende Verschlusselemente aufgespritzt sind, die nach dem Zusammenklappen miteinander in Wirkverbindung stehen, werden in aufgeklappter Position der Gehäusewände die Seitenwände eingesteckt, wobei eine Befestigung durch Schnappverschlüsse erfolgt. Aus der Vielzahl der Bauteilkomponenten, die dieses Gehäuse erfordert, resultiert der hohe Aufwand zu seiner Herstellung und somit ebenfalls ein kostenungünstiges Gehäuse.

Der Herstellungsaufwand ist aber auch bei derartigen Gehäusen verhältnismäßig hoch, die - wie weiterhin durch die DE 195 01 340 C1 bekannt - aus einem u-förmigen Blech bestehen, bei dem zwei Stirnkanten zu einer Pastenform hochgebogen sind, oder bei dem Endstücke an das U-Mantelblech angeschweißt, angenietet oder mit diesem verschraubt sind und der Deckel aufgeschraubt ist.

Derartige Profile werden an Wänden beziehungsweise Gestellen befestigt und bieten die Möglichkeit, Kabel beziehungsweise Kabelkanäle und elektronische Bauelemente an den Innenseiten der Schenkel der Profile anzuordnen. Dabei wird die Montagefreiheit und das zur Verfügung stehende Bauvolumen bei einem U-Profil durch den Abstand der beiden Schenkel begrenzt. Die Zugänglichkeit ist nur in dem vom U-Profil geöffneten Bereich sowie von den Stirnseiten des Profils gegeben. Bei Verwendung eines Kastenprofils ist die Zugänglichkeit ausschließlich auf die Stirnseiten beschränkt.

Gegenüber U- beziehungsweise Kastenprofilen bieten L-Profile verbesserte Möglichkeiten hinsichtlich der Zugänglichkeit bei der Montage und/oder der Wartung. Nachteilig bei der alleinigen Verwendung eines L-Profils ist allerdings, dass die elektronischen Bauelemente, die auf den Innenseiten der Schenkel des L-Profils angeordnet sind, relativ ungeschützt Umgebungseinflüssen ausgesetzt sind. Zur Behebung dieses Nachteiles werden dazu derartige L-Profile mit bevorzugt gleichen L-Profilen abgedeckt, so dass die Enden der L-Profile mechanisch miteinander verbunden sind. Nachteilig an dieser Ausführungsform ist allerdings ein möglicher Wärmestau in den dadurch hergestellten sehr kompakten Kastenprofilen durch deren auf das Volumen bezogene relativ geringe Oberfläche.

Derartige L-Profile, die zu einem Kastenprofil miteinander verbunden werden, sind zum Beispiel in der DE 20 2006 006 133 U1 offenbart.

Weiterhin nachteilig an dieser Ausführungsform ist, dass das durch die L-Profile umschlossene Volumen unveränderbar ist und demzufolge die Anordnung weiterer Bauelemente im von den Profilschenkeln umgebenden Hohlraum nur mit erhöhtem konstruktiven und technologischen Aufwand an oder in den L-Profilen realisiert werden kann.

Der vorliegenden Erfindung liegt somit die Aufgabe zugrunde, ein Kastenprofil zur Verfügung zu stellen, mit dem in einfacher und kostengünstiger Weise ein relativ geringes und begrenztes inneres Volumen mit einer Vielzahl von flexiblen Befestigungsmöglichkeiten und gleichzeitiger Realisierung einer ausreichenden Bauteilkühlung geschaltet werden kann.

Diese Aufgabe wird durch das erfindungsgemäße Kastenprofil nach Anspruch 1 sowie ein System aus miteinander verbundenen Kastenprofilen gemäß Anspruch 2 gelöst.

Erfindungsgemäß wird ein Kastenprofil zur Verfügung gestellt, welches wenigstens zwei Winkelprofile umfasst, wobei das zweite Winkelprofil in einer in Bezug zur Position des ersten Winkelprofils um 180° gedrehten Lage mit beiden Schenkelenden mit den Schenkelenden des ersten Winkelprofils mechanisch verbunden ist. Es wird somit ein Kastenprofil zur Verfügung gestellt, welches an wenigstens zwei Seiten Kühlrippen aufweist.

Dieses Kastenprofil umfasst ein in das Kastenprofil eingeschobenes drittes Winkelprofil, wobei die Länge des ersten Schenkels des dritten Winkelprofils im Wesentlichen der Länge des Kastenprofils entspricht und die Breite des dritten Winkelprofils der lichten Höhe des Kastenprofils entspricht und damit der erste Schenkel des dritten Winkelprofils den vom Kastenprofil umschlossenen Raum in zwei Einzelräume unterteilt, wobei der zweite Schenkel des dritten Winkelprofils zumindest einen Teil einer Stirnwand für das Kastenprofil ausbildet. Bevorzugt sind mehrere dritte, hinsichtlich der Länge ihrer zweiten Schenkel gegebenenfalls unterschiedliche Winkelprofile in das Kastenprofil eingeschoben, so dass die Stirnwand des Kastenprofils im Wesentlichen geschlossen ist und mehrere Raumunterteilungen des vom Kastenprofil umschlossenen Hohlraumes vorgenommen sind. Das dritte Winkelprofil ist bevorzugt in eine der integral am Winkelprofil ausgebildeten Nutenschienen eingeschoben. In dieser Situation können die stirnseitigen Enden anderer Nutenschienen zur Bereitstellung eines Einschraubkanals für eine Gewindeschraube zur Befestigung des zweiten Schenkels des dritten Winkelprofils dienen.

Die erfindungsgemäßen Kastenprofile können dabei mittels Befestigungselementen, die bevorzugt an ihren Längsseiten angeordnet sind, zu einem System von mindestens zwei miteinander verbundenen Kastenprofilen verbunden sein, wobei die an einem ersten Kastenprofil vorgesehenen Befestigungselemente an komplementär ausgebildeten zweiten Befestigungselementen am zweiten Kastenprofil fixiert sind. Es kann somit eine Einheit einer Vielzahl von Kastenelementen zur Verfügung gestellt werden, die alle im Wesentlichen parallel zueinander mechanisch verbunden sind.

Hierbei wird ein Winkelprofil mit zwei Schenkeln eingesetzt, welches derart ausgestaltet ist, dass es mit einem hinsichtlich der Schenkellängen und Winkelgleichen und in Bezug zum Winkelprofil um 180° gedrehten zweiten Winkelprofil zu einem in sich geschlossenen Kastenprofil mechanisch verbindbar ist, wobei wenigstens an einem Schenkel eine Mehrzahl von parallel zueinander verlaufenden Kühlrippen angeordnet sind. Wenigstens eine erste und eine zweite Kühlrippe weist dabei ein erstes Formelement auf, wobei die beiden ersten Formelemente derart ausgestaltet sind, dass mit ihnen eine formschlüssig wirkende Arretierung wenigstens eines Anbauteiles in wenigstens zwei translatorischen Freiheitsgraden auf den Kühlrippen realisierbar ist. Die Kühlrippen verlaufen dabei vorzugsweise in Längserstreckungsrichtung und über die gesamte Länge des Winkelprofils und bilden dabei z. B. eine Hutschiene aus. Die Formelemente an den Kühlrippen sind dabei vorzugsweise im Wesentlichen symmetrisch zueinander anzuordnen. Die Arretierung des Anbauteiles zur Fixierung im dritten translatorischen Freiheitsgrad wird gegebenenfalls kraftschlüssig durch Reibkräfte erzeugt, wie zum Beispiel durch Anziehen einer Schraubverbindung. Vorzugsweise ist das Winkelprofil ein mittels Strangguss hergestelltes Profil aus Aluminium. Bei Stranggussprofilen kann das gepresste Material (z. B. 6-Meter Stangen) auf die gewünschte Länge zugeschnitten werden. Ein konkretes Gehäuse ergibt sich somit durch den geeigneten Zuschnitt sowie durch die Erzeugung der erforderlichen Öffnungen in den Materialwänden durch Nachbearbeitung wie z. B. Fräsen, Lasern, etc. Das heißt, dass Stranggussprofile einen Großteil der Gehäuse-Merkmale in standardisierter Form bereitstellen und sehr flexibel durch Zuschnitt und Nachbearbeitung an verschiedene Systemgrößen sowie an den jeweiligen Verwendungszweck angepasst werden können.

Es bietet sich dabei an, das Winkelprofil als L-Profil auszuführen, das heißt mit einem Winkel von 90° zwischen den Schenkeln und unterschiedlich langen Schenkeln. Die Arretierung des Anbauteiles in den zwei translatorischen Freiheitsgraden ist dabei zum Beispiel mittels Klemmung oder Rastung realisierbar. Der Vorteil der Erfindung liegt insbesondere darin, dass die Kühlrippen eine dreifache Funktion erfüllen, nämlich eine Vergrößerung ihrer Oberfläche durch die Integration der Formelemente bei gleichzeitiger Schaffung der Möglichkeit der Befestigung von Anbauteilen sowie außerdem Erhöhung des Flächenträgheitsmomentes des Winkelprofils und somit Erhöhung von dessen Tragfähigkeit. An dem erfindungsgemäßen Winkelprofil lassen sich somit nicht nur in dem von den Winkelschenkeln umschlossenen Bereich, sondern ebenfalls in einfacher und flexibler Weise auf den üblicherweise an den Außenseiten der Schenkel angeordneten Kühlrippen Bauteile fixieren oder die Winkelprofile selbst über die Kühlrippen an Wänden, Gestellen oder anderen Bauteilen befestigen.

Es ist dabei bevorzugt vorgesehen, dass die Kühlrippen ein Verhältnis von Höhe zu Breite von mindestens 5:1 aufweisen. Das heißt, dass mit den zur Befestigung vorgesehenen Kühlrippen relativ dünne und relativ weit vom eigentlichen Winkelprofil abstehende Profilbestandteile gemeint sind. Die Angabe der Breite der Kühlrippe erfolgt dabei jedoch ohne Beachtung der Breite der Formelemente. Das heißt, dass übliche Nuten oder Schienen an den Winkelprofilen nicht unter die hier genannten Kühlrippen fallen. Dabei schließt die vorliegende Erfindung allerdings nicht aus, dass an den erfindungsgemäßen Winkelprofilen Nuten oder Schienen, gegebenenfalls integral mit dem Winkelprofil ausgeformt, vorhanden sind.

Vorteilhafterweise sind die Formelemente an den Kühlrippen Absätze. Diese Absätze verlaufen wie die Kühlrippen über die gesamte Länge der Winkelprofile und sind bevorzugt an dem am weitesten vom Winkelprofilschenkel entfernten Kühlrippenbereich angeordnet. Dabei können die Absätze derart an den Kühlrippen angeordnet sein, dass sie jeweils einander zugewandt sind. Das heißt, dass ein jeweiliger Absatz an der Kühlrippenseite angeordnet ist, auf der sich die andere, zweite mit Absatz versehene Kühlrippe befindet. In alternativer Ausgestaltung ist vorgesehen, dass die Absätze voneinander abgewandt an den Kühlrippen angeordnet sind. Das heißt, in dieser Ausgestaltung ist der Absatz an einer Kühlrippe an der Seite angeordnet, die der Seite gegenüberliegt, auf der sich die andere, zweite Kühlrippe mit Absatz befindet.

In beiden alternativen Ausführungsformen kann vorgesehen sein, dass zwischen den die Absätze aufweisenden Kühlrippen weitere Kühlrippen angeordnet sind. Diese weiteren Kühlrippen können jeweils mit oder ohne Absätze ausgeführt sein.

Wenigstens zwei Kühlrippen können jeweils ein zweites Formelement aufweisen, wobei die zweiten Formelemente derart ausgestaltet sind, dass mit ihnen und/oder den ersten Formelementen ein Anbauteil an den Kühlrippen befestigt werden kann. Dies kann derart ausgestaltet sein, dass eine formschlüssig wirkende Arretierung wenigstens eines Anbauteiles in wenigstens zwei translatorischen Freiheitsgraden auf den Kühlrippen realisierbar ist. Auch diese zweiten Formelemente sind vorzugsweise im Wesentlichen symmetrisch zueinander angeordnet und jeweils in Form eines Absatzes ausgebildet. Diese Ausgestaltung ist insbesondere dann sinnvoll, wenn die Kühlrippen mit dem zweiten Formelement die erste und die zweite Kühlrippe sind, wobei das erste und das zweite Formelement an jeder Kühlrippe übereinander angeordnet sind. Das heißt, es können die beiden Kühlrippen mit dem zweiten Formelement die erste und die zweite Kühlrippe sein, so dass die erste und die zweite Kühlrippe jeweils zwei Formelemente, nämlich das erste und das zweite Formelement, aufweisen. In diesem Fall sind das erste und das zweite Formelement übereinander an einer Kühlrippe angeordnet. Die Form der Absätze kann dabei genauso oder ähnlich sein, wobei jeweils nur ihr Abstand zum Schenkel unterschiedlich ist. Insbesondere können die beiden Formelemente an derselben Seite der jeweiligen Kühlrippe angeordnet sein. Der Vorteil dieser Ausgestaltung liegt insbesondere darin, dass an einem Paar von mit den beiden Formelementen ausgestalteten Kühlrippen in unterschiedlichen Höhen zum Beispiel Nutensteine einschiebbar sind, so dass diese sich bei ihrer Montage beziehungsweise Demontage nicht behindern. So können zum Beispiel Nutensteine in eine durch erste Formelemente an zwei Kühlrippen gebildete Nutenschiene, die sich in weiterer Entfernung von einem Schenkel des Winkelprofils befindet, als eine durch zweite Formelemente an denselben Kühlrippen gebildete, darunter liegende Nutenschiene eingeschoben werden, und zusammen mit Bolzen zur Befestigung weiterer Bauelemente auf den Kühlrippen oder zur Befestigung des Winkelprofils zum Beispiel an einem Gestell dienen. Diese Befestigungen behindern nicht das Einschieben weiterer Nutensteine in die darunter liegende, durch die zweiten Formelemente ausgebildete Nut. Es lässt sich somit in flexibler Weise bei bereits erfolgter Befestigung von Bauelementen auf den Kühlrippen oder Befestigung der Winkelprofile weitere Befestigungen anderer Bauelemente oder Befestigung des Winkelprofils selbst über die gesamte Länge des Winkelprofils flexibel vornehmen.

Daneben ist allerdings auch die Ausgestaltung umfasst, bei der andere Kühlrippen als die mit den ersten Formelementen versehenen Kühlrippen mit dem zweiten Formelement versehen sind. Außerdem kann vorgesehen sein, dass die erste oder die zweite Kühlrippe mit dem zweiten Formelement versehen ist und eine weitere, nicht mit dem ersten Formelement versehene Kühlrippe mit dem zweiten Formelement versehen ist. Hinsichtlich der Form eines Absatzes können die zweiten Formelemente genauso wie die ersten Formelemente ausgestaltet sein. Hinsichtlich ihrer Position können die zweiten Formelemente, insofern sie nicht an der ersten oder zweiten Kühlrippe angeordnet sind, genauso wie an der ersten oder zweiten Kühlrippe vorgesehen angeordnet sein.

Zur Ausbildung von Gehäusen durch die mechanische Verbindung der Winkelprofile miteinander zu Gehäusen mit standardisierten Außenmaßen ist vorzusehen, dass die Länge eines Schenkels des Winkelprofils als Außenseite eines Baugruppenträgers- zwischen 150 mm und 180 mm, bevorzugt 170 mm , und die Länge des anderen Schenkels zwischen 40 mm und 50 mm, bevorzugt 45 mm beträgt.

Bei dem bevorzugten Verhältnis von Höhe zur Breite von mindestens 5:1 kann die Kühlrippenhöhe zum Beispiel 15 bis 25 mm, bevorzugt 20 mm, und die Kühlrippenbreite zwischen 2 und 6 mm, bevorzugt 4 mm, betragen.

Zur Ausbildung weiterer Befestigungsmöglichkeiten kann das Winkelprofil derart ausgestaltet sein, dass an wenigstens einem der Schenkel wenigstens eine Nutenschiene angeordnet ist, und dass außerdem auf der Schenkelinnenseite ein Schraubkanal ausgebildet ist, in den eine Gewindeschraube stirnseitig einschraubbar ist. Dabei kann eine solche Nutenschiene auf oder in dem Schenkel integral mit dem Winkelprofil, zum Beispiel im Zuge des Stranggussverfahrens hergestellt sein.

Die Möglichkeit der Einschraubung einer Gewindeschraube in den Schraubkanal kann dabei durch ein in der Stirnseite des Schraubkanals vorgesehenes Gewinde gegeben sein oder durch eine entsprechende Dimensionierung des Schraubkanals, in den eine selbst schneidende Gewindeschraube einschraubbar ist. Nutenschiene und Schraubkanal können derart angeordnet sein, dass ein Formelement der Nutenschiene gleichzeitig ein Formelement des Schraubkanals ist, zum Beispiel, wenn Nutenschiene und Schraubkanal unmittelbar nebeneinander ausgebildet sind, wobei eine seitliche Wand der Nutenschiene gleichzeitig eine seitliche Wand des Schraubkanals bildet.

In die Nutenschiene, die einen rechteckig geformten Hohlraum aufweist, werden seitlich Schraubenmuttern oder Gewindesteifen eingeführt, so dass man Leiterkarten oder andere Dinge von oben mit geeigneten Schrauben befestigen kann, indem die Schraube durch das zu befestigende Objekt in das Gegenstück, die Mutter oder den Gewindestreifen eingeschraubt wird. Bevorzugt befinden sich auf einem Schenkel eine Mehrzahl von derartigen Nutenschienen zur flexiblen Befestigung von Gegenständen.

In weiterer Ausgestaltung ist vorgesehen, dass das Winkelprofil eine Hutschiene umfasst, die mittels der ersten und/oder der zweiten Formelemente an den Kühlrippen an diesen ausgebildet ist. Auf dieser Hutschiene können mittels Klemmung und/oder Rastung ein oder mehrere Anbauteile befestigt sein. Gegebenenfalls kann eine Zugkraft zur Erzeugung einer Reibkraft zur Fixierung des Anbauteils im dritten translatorischen Freiheitsgrad und allen rotatorischen Freiheitsgraden auf das Anbauteil aufgebracht sein.

In weiterer Ausgestaltung ist vorgesehen, dass das Winkelprofil wenigstens einen als ein Bestandteil des Schenkels ausgeführten Kabelkanal umfasst, wobei in einer Außenwand des Kabelkanals wenigstens eines der beiden Förmelemente vorhanden ist. Das heißt, dass auch der Kabelkanal mit einer der Kühlrippen die beiden Formelemente zur Verfügung stellen kann, mittels derer das Anbauteil befestigt werden kann. Der Kabelkanal selbst weist Befestigungselemente wie zum Beispiel Bohrungen zur Fixierung eines weiteren Winkelprofils am Winkelprofil auf.

Außerdem wird eine Leiterplatteneinheit zur Verfügung gestellt, welche ein Winkelprofil mit zwei Schenkeln umfasst, wobei das Winkelprofil derart ausgestaltet ist, dass es mit einem hinsichtlich der Schenkellängen und Winkel gleichen und im Bezug zum Winkelprofil um 180° gedrehten, zweiten Winkelprofil zu einem in sich geschlossenen Kastenprofil mechanisch verbindbar ist, und dass es auf der Innenseite eines Schenkels wenigstens eine montierte Leiterplatte aufweist. Die Leiterplatteneinheit ist somit eine Einheit aus Winkelprofil und daran befestigter Leiterplatte, wobei die Leiterplatte in ihren Abmaßen bevorzugt europäischen Standartmaßen entspricht. Eine solche Leiterplatteneinheit kann erfindungsgemäß Bestandteil eines Kastenprofils sein, wobei an die Leiterplatteneinheit ein zweites Winkelprofil in einer im Bezug zur Position der Leiterplatteneinheit um 180° gedrehten Lage mit beiden Schenkelenden mit den Schenkelenden der Leiterplatteneinheit mechanisch verbunden ist. Dabei kann die Erfindung auch derart ausgestaltet sein, dass zwei Leiterplatteneinheiten bzw. deren Winkelprofile zur Herstellung des Kastenprofils miteinander verbunden sind. Das Winkelprofil, welches ein Bestandteil der Leiterplatteneinheit ist, kann außen im Wesentlichen mit glatter Schenkel-Wandung ausgeführt sein oder auch die erfindungsgemäßen Kühlrippen aufweisen.

Die Leiterplatteneinheit kann jedoch auch zur Herstellung eines weiteren Kastenprofils dienen, in welches mit einem Schenkel eine Trennwand des Kastenhohlraumes realisierend die Leiterplatteneinheit eingeschoben ist. D. h., dass ein und dieselbe Leiterplatteneinheit zur Herstellung der Hälfte eines Kastenprofils oder auch zur Herstellung einer Unterteilung eines Kastenprofilhohlraumes dienen kann.

Eine derartige Kastenhohlraumunterteilung kann dadurch hergestellt werden, indem von einem Kastenprofil, welches als Außenwandung die Leiterplatteneinheit aufweist, diese Leiterplatteneinheit demontiert wird und vom zweiten Winkelprofil separiert wird und danach die Leiterplatteneinheit in ein Kastenprofil eingeschoben wird, so dass ein Schenkel der Leiterplatteneinheit eine Trennwand des Kastenhohlraumes realisiert.

In umgekehrter Weise lässt sich auch ein Kastenprofil herstellen, bei dem ein Teil der Außenwandung durch die Leiterplatteneinheit hergestellt ist, indem die Leiterplatteneinheit aus einem Kastenprofil, in dem sie eine Trennwand im Kastenhohlraum erzeugt, herausgezogen wird und im dadurch separierten Zustand danach mit einem zweiten Winkelprofil in einer im Bezug zur Position der Leiterplatteneinheit um 180° gedrehten Lage mit beiden Schenkelenden mit dem Schenkelenden des zweiten Winkelprofils verbunden wird.

Die Leiterplatteneinheit hat somit zwei Funktionen, nämlich einmal die Herstellung einer Hälfte eines Kastenprofils, bei dem die Schenkel des Winkelprofils der Leiterplatteneinheit die eine Hälfte der Außenwandung des Kastenprofils bilden, und zweitens die Erzeugung einer Hohlraumunterteilung in einem größeren Kastenprofil, in welches die Leiterplatteneinheit eingeschoben ist. Diese Ausgestaltung ist insbesondere in den Fällen vorteilhaft, in denen Leiterplatte mit mehr oder anderen elektronischen Bauelementen, wie z. B. mit weiteren Leiterplatten, elektronisch verbunden werden soll, wobei sie auf einem Winkelprofil montiert verbleibend in beschriebener Art und Weise von dem weiteren das Kastenprofil ausbildenden Winkelprofil abgeschraubt werden kann und in einfacher Weise in ein größeres Kastenprofil, welches bevorzugt mehr oder andere elektronische Bauelemente aufweist, eingeschoben werden kann und dort mit diesen Bauelementen verbunden werden kann.

In umgekehrter Weise lässt sich ein in ein größeres Kastenprofil eingeschobenes Leiterplattenelement in einfacher Weise aus diesem durch Herausziehen entfernen und mit einem weiteren Winkelprofil zu einem eigenem, kleineren Kastenprofil verbinden, welches flexibel unabhängig vom größeren Kastenprofil montiert werden kann. Dadurch entfallen insbesondere Umbau- und Montagekosten sowie ggf. Kosten für extra Leiterplatten, die nach Verwendung einer Leiterplatte in einem kleineren oder in einem größeren Kastenprofil zusätzlich als Bestandteil eines kleineren Kastenprofils oder auch als Einschub in einem größeren Kastenprofil zu verwenden sind.

Die Erfindung wird im Folgenden anhand der beiliegenden Zeichnungen näher beschrieben. Es zeigen dabei:
- Figur 1: ein erstes Winkelprofil in perspektivischer Ansicht;
- Figur 2: ein durch ein erstes und zweites Winkelprofil ausgebildetes Kastenprofil in perspektivischer Ansicht;

- Figur 3: ein erstes Winkelprofil mit Kühlrippen in perspektivischer Ansicht;
- Figur 4: ein aus einem ersten und zweiten Winkelprofil zusammengesetztes Kastenprofil mit Kühlrippen am ersten Winkelprofil;
- Figur 5: ein aus einem ersten und zweiten Winkelprofil zusammengesetztes Kastenprofil mit Kühlrippen an beiden Winkelprofilen in perspektivischer Ansicht;
- Figur 6: das in Figur 5 dargestellte Kastenprofil mit integrierter Hutschiene und einem aufgeklemmten Anbauteil;
- Figur 7: ein weiteres erstes Winkelprofil in perspektivischer Ansicht;
- Figur 8: ein weiteres zweites Winkelprofil in perspektivischer Ansicht;
- Figur 9: ein drittes Winkelprofil in perspektivischer Ansicht;
- Figur 10: ein drittes Winkelprofil in alternativer Ausgestaltung in perspektivischer Ansicht;
- Figur 11: ein aus erstem und zweitem Winkelprofil zusammengesetztes Kastenprofil mit eingeschobenen dritten Winkelprofilen in perspektivischer Ansicht;
- Figur 12: unterschiedliche, aus ersten und zweiten Winkelprofilen hergestellte Kastenprofile und
- Figur 13: ein System aus miteinander verbundenen unterschiedlichen Kastenprofilen in perspektivischer Ansicht.

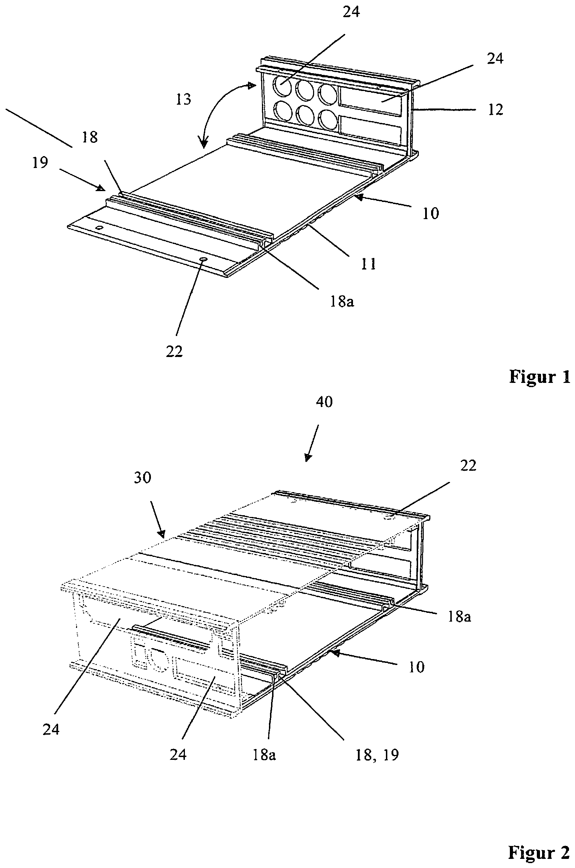

In Figur 1 ist das erste Winkelprofil 10 dargestellt, welches einen ersten Schenkel 11 und einen zweiten Schenkel 12 umfasst, die zusammen einen Winkel 13, bevorzugt 90°, einschließen. Am zweiten Schenkel 12 sind Öffnungen 24 zur Durchführung von Datenleitern oder Datenleitungsverbindungselementen wie z. B. Steckern oder Kabeln vorgesehen. Am ersten Schenkel 10 sind Nutenschienen 18 angeordnet, die bevorzugt integral durch das zur Herstellung des Winkelprofils genutzte Stranggussverfahren hergestellt sein können.

Neben den Nutenschienen 18 sind Schraubkanäle 18a angeordnet, wobei eine Seitenwand der Nutenschiene auch gleichzeitig eine Begrenzung des Schraubkanals ausbildet. Dabei ist die Erfindung nicht auf die dargestellte miteinander direkt verbundene Anordnung von Nutenschiene 18 und Schraubkanal eingeengt, sondern Nutenschiene 18 und Schraubkanal 18a können auch getrennt voneinander auf dem Schenkel angeordnet sein.

Zur Befestigung von Winkelschenkelenden eines zweiten Winkelprofils sind an den jeweiligen Schenkelenden des ersten Winkelprofils 10 Bohrungen 22 vorgesehen.

In Figur 2 ist dargestellt, wie durch die Verbindung der Winkelschenkelenden eines ersten Winkelprofils 10 mit denen eines zweiten Winkelprofils 30 ein erstes geschlossenes Kastenprofil 40 herstellbar ist. Es ist ersichtlich, dass auch am zweiten Winkelprofil 30 Öffnungen 24 zur Durchführung von Kabeln und/oder Steckern vorgesehen sein können, wobei diese Öffnungen 24 anders geformt sein können als die Öffnungen am zweiten Schenkel 12 des ersten Winkelprofils 10. Das erste und das zweite Winkelprofil 10 und 30 sind somit im Wesentlichen baugleich ausgeführt.

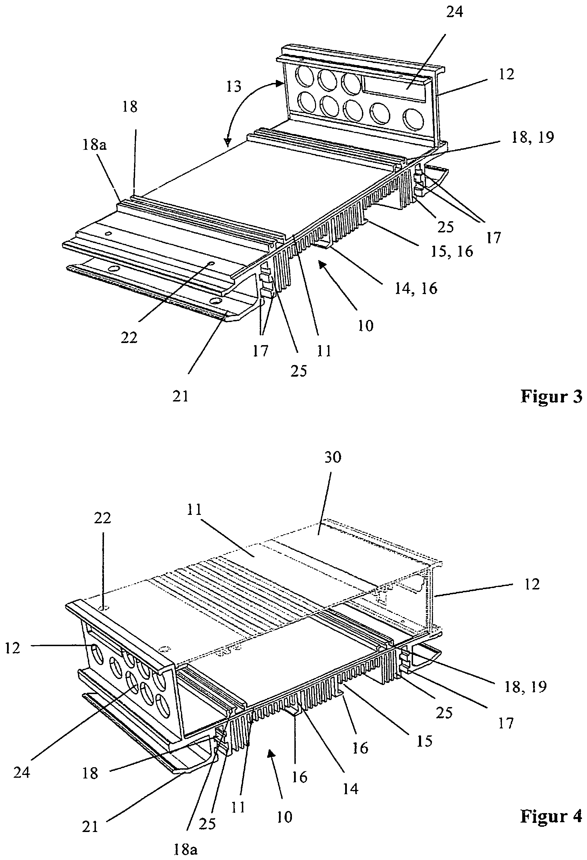

In den Figuren 3 und 4 ist dargestellt, dass am ersten Winkelprofil 10 Kühlrippen angeordnet sein können zur Vergrößerung der Oberfläche des ersten Schenkels 11 zum Zweck der Verbesserung der Wärmeableitung aus dem Winkelprofil an die Umgebungsluft. Es ist erfindungsgemäß eine erste Kühlrippe 14 und eine zweite Kühlrippe 15 angeordnet, die jeweils ein erstes Formelement 16, in Form eines Absatzes, aufweisen und somit eine Hutschiene ausbilden. Außerdem ist am ersten Schenkel 11 des ersten Winkelprofils 10 ein Kabelkanal 21 ausgebildet, der zwei zweite Formelemente 17 aufweist, die gegenüberliegend zu zwei weiteren zweiten Formelement 17 an einer dritten Kühlrippe 25 ausgebildet sind. Zwischen dem Kabelkanal 21 und der dritten Kühlrippe 25 ist durch die Anordnung der zweiten Formelemente 17, die ebenfalls in Form von Absätzen ausgeführt sind, zwei Nutenschienen 18 ausgebildet, wobei eine Nutenschiene dichter am ersten Schenkel 11 angeordnet als die andere Nutenschiene.

Aus Figur 4 ist ersichtlich, dass ein durch das erste Winkelprofil 10 und zweite Winkelprofil 30 ausgebildetes Kastenprofil dabei nicht unbedingt an gegenüberliegenden Seiten die Kühlrippen aufweisen muss, sondern dass die Kühlrippen gegebenenfalls auch nur an einem Winkelprofil angeordnet sein können.

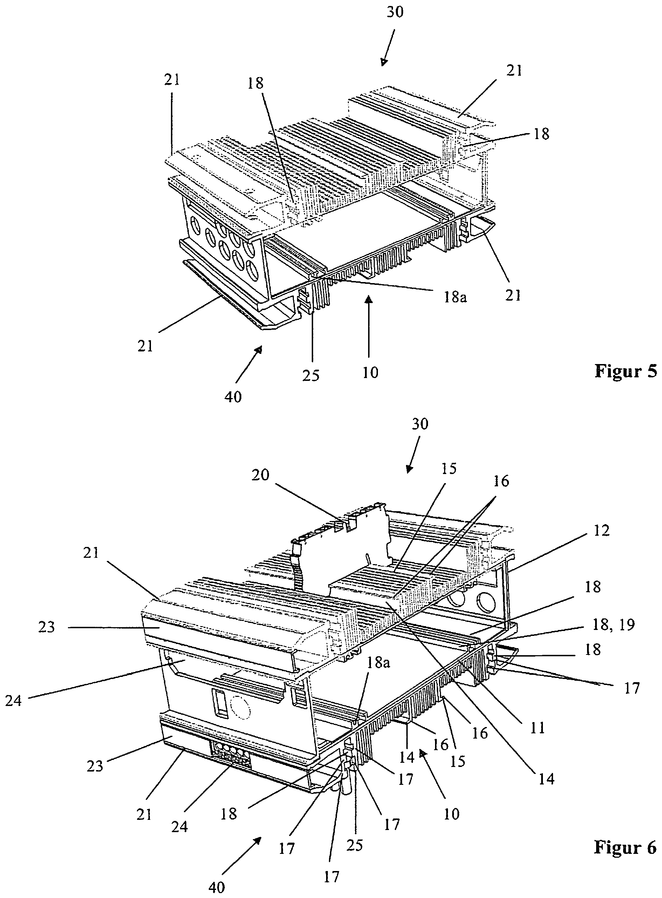

In Figur 5 ist die Ausführungsform gezeigt, an der die Kühlrippen an beiden Winkelprofilen 10, 30 angeordnet sind und somit eine symmetrische Ausgestaltung, auch in Bezug auf die an den Winkelprofilen 10, 30 angeordneten Kabelkanäle 21, realisiert ist.

In Figur 6 ist die in Figur 5 dargestellte Variante des ersten Kastenprofils 40 gezeigt, bei der auf der durch die Formelemente 16 gebildeten Hutschiene auf der ersten Kühlrippe 14 und der zweiten Kühlrippe 15 ein Anbauteil 20 festgeklemmt ist. Eine translatorische Bewegung des Anbauteils 20 in Richtung der Längserstreckung der Kühlrippen wird alleine durch die Klemmwirkung verhindert.

Die Hutschiene kann also sowohl verwendet werden, um auf einem Kastenprofil gemäß Figur 6 Zusatzkomponenten (wie z. B. Anbauteile) aufzurasten als auch um das Kastenprofil gemäß Figur 6 selbst auf ein geeignet gestaltetes Gegenstück aufzurasten, wobei dieses Gegenstück vorteilhafterweise fest mit dem Installationsort verbunden ist.

Aus den Figuren 5 und 6 ist ersichtlich, dass die zwischen dem Kabelkanal 21 und einer Kühlrippe 25 durch die zweiten Formelemente 17 gebildeten Nutenschiene 18 einen jeweils unterschiedlichen Abstand in Bezug zum ersten Schenkel 11 aufweisen). Für den Fachmann ist erkennbar, dass in jede der dadurch gebildeten Nutenschienen 18 Nutensteine eingeschoben werden können, wobei sich diese hinsichtlich ihrer Position, bezogen auf die Länge des Winkelprofils, nicht behindern. Es wird somit eine flexible und hinsichtlich der Position leicht verstellbare Befestigungsmöglichkeit für weitere Anbauteile beziehungsweise für das Kasten- oder Winkelprofil selbst zur Verfügung gestellt. Die Formelemente können miteinander derartige Nuten ausbilden, in die Nutensteine für Gewinde M4 oder Innensechskant- oder Sechskantschraubenköpfe von Bolzen mit Gewinde M4 oder auch Gewinden M5 einschiebbar sind, wobei die dichter am Schenkel angeordnete Nut eine geringere Breite als die weiter vom Schenkel entfernt angeordnete Nut. Dies hat den Vorteil der geringeren Materialschwächung des Übergangsbereiches zwischen Rippe und Schenkel und damit der verbesserten Festigkeit.

In Figur 6 ist außerdem erkennbar, dass der Kabelkanal 21 eine Abdeckplatte 23 aufweist, die wiederum Öffnungen 24 aufweist, die ebenfalls zur Durchführung von Steckern oder Kabeln dienen können. Die Abdeckplatte 23 ist ein quer zur Längsrichtung gekerbtes Kunststoffteil, das durch Abbrechen auf geeignete Längenelemente verkürzt werden kann, die dann abschnittsweise die Abdeckung des Kabelkanals bilden. Diese Längenelemente werden federnd eingeklemmt. Die Bohrungen 22 im Kabelkanal dienen zum Verschrauben von zwei um 180° gegeneinander verdrehten Winkelprofilen gemäß Figur 3 zu einem Kastenprofil gemäß Figur 6.

In Abbildung 6 ist außerdem eine Wago-Klemme 24 dargestellt, die seitlich in den Kabelkanal 21 eingeführt wurde, der links und rechts der positionierten Wago-Klemme mit den gekerbten Kunststoff-Abdeckungen geschlossen ist. Derartige Wago-Klemmen dienen dazu, mehrere Leitungen mit möglicherweise unterschiedlichem Leitungsquerschnitt elektrisch miteinander zu verbinden.

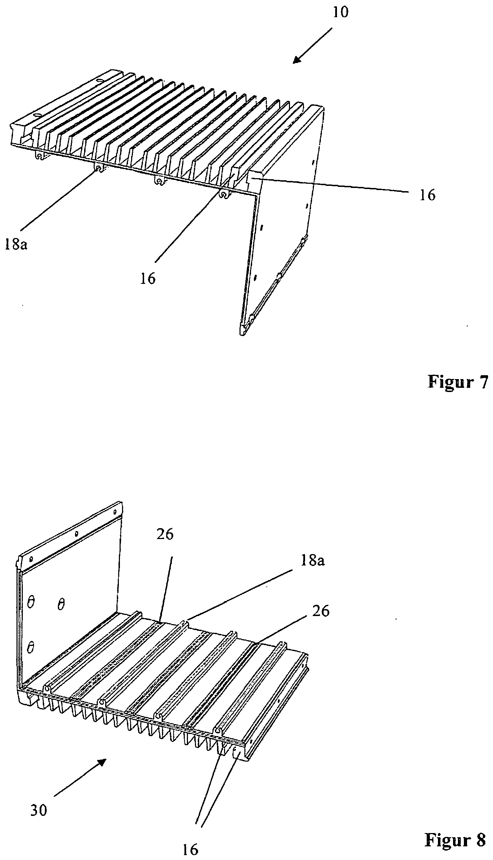

In den Figuren 7 und 8 sind erste und zweite Winkelprofile 10, 30 mit anderen geometrischen Maßen als die Winkelprofile in den Figuren 1 bis 6 dargestellt, wobei an den in den Figuren 7 und 8 dargestellten Winkelprofilen 10, 30 an jeweils einem Schenkel Führungsschienen 26 bevorzugt in regelmäßigen Abständen angeordnet sind. Des Weiteren weisen beide Winkelprofile 10, 30 an Kühlrippen erste Formelemente 16 auf.

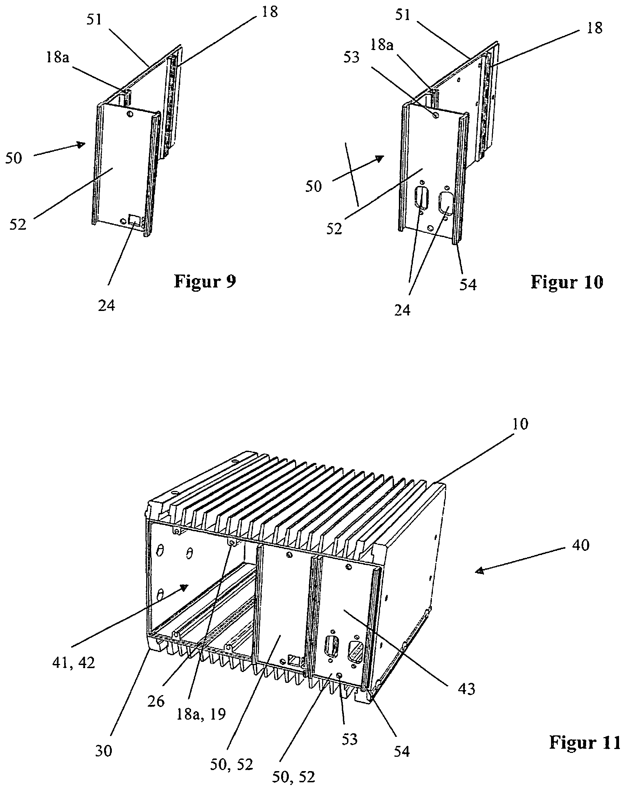

In Figur 10 ist ein drittes Winkelprofil 50 dargestellt, dass (wie in Figur 11 gezeigt) in ein erstes, durch zwei Winkelprofil gebildetes Kastenprofil 40 einschiebbar ist. Das dritte Winkelprofil 50 kann dabei gemäß des in Figur 1 dargestellten Winkelprofils ausgestaltet sein. Zur Positionierung des dritten Winkelprofils 50 in dem vom Kastenprofil 40 umschlossenen Raum 41 wird das dritte Winkelprofil 50 mit seinem ersten Schenkel 51 in die Führungsschienen 26, die einander am ersten Winkelprofil 10 und am zweiten Winkelprofil 30 gegenüber liegen, eingeschoben. Ein zweiter Schenkel 52 des dritten Winkelprofils 50 bildet dabei einen Teil der Stirnwand 43 des ersten Kastenprofils 40 aus. Es ergeben sich dadurch Unterteilungen des vom Kastenprofil umschlossenen Raums 41 in Einzelräume 42.

Wie aus den Figuren 9, 10 und 11 ersichtlich ist, können dabei die zweiten Schenkel 52 des dritten Winkelprofils 50 insbesondere hinsichtlich der Öffnungen 24 unterschiedliche Ausgestaltungen haben, um im eingeschobenen Zustand der dritten Winkelprofile 50 die Anordnung unterschiedlicher Bauelemente in den durch die dritten Winkelprofile 50 geschaffenen Einzelräume 42 realisieren zu können beziehungsweise deren Montage vereinfachen zu können.

Die Kastenprofile gemäß Figuren 7 und 8 haben zwischen einigen ihrer benachbarten Kühlrippen einen derart großen Abstand, dass problemlos durch dort befindliche Bohrungen Schrauben hindurchgeführt und, wenn die Winkelprofile zu Kastenprofilen gemäß der Figuren 11 bis 13 verbunden sind, Schraubverbindungen mit in das Kastenprofil eingeschobenen kleineren Profilwinkeln durch Einschrauben in deren Schraubkanäle 18a erzeugt werden. Der Abstand der Kühlrippen ist dabei derart bemessen, dass sich zwischen ihnen ein Werkzeug zum automatisierten Verschrauben drehen kann.

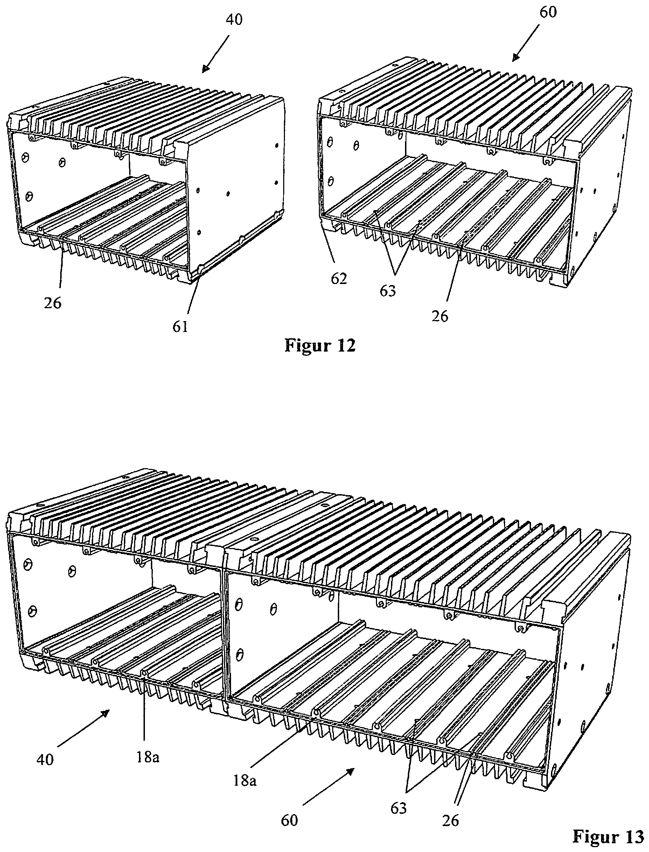

Nutenschienen 18 und Einschraubkanäle 18a verlaufen dabei nicht über die gesamte Länge des längeren Schenkels, sondern enden kurz vor den Rändern des Schenkels, um eine Einschiebbarkeit in das erste Kastenprofil gemäß Figur 12 bzw. in die dort angeordneten Schienen 26 zu ermöglichen.

Bevorzugt sind dabei die längeren Schenkel des in den Figuren 9 und 10 dargestellten dritten Winkelprofils kurz vor dem Verbindungsbereich der beiden Schenkel etwas breiter ausgeführt, so dass es bei vollständiger Einschiebung des dritten Winkelprofils in das Kastenprofil 40 gemäß Figur 11 zu einer leichten Klemmung zwischen den Schienen 26 und dem Schenkel kommt. Dies hat den Vorteil, dass über den längeren Einschiebeweg eine ungehinderte Einschiebung möglich ist und erst kurz vor Erreichung der Endposition gemäß Figur 11 eine Klemmkraft das dritte Winkelprofil im Kastenprofil 40 fixiert, wobei jedoch die erzeugte Klemmkraft nur derart stark ausgeführt sein sollte, dass das dritte Winkelprofil manuell ein- und ausschiebbar bleibt.

Am zweiten, kürzeren Schenkel 52 des dritten Winkelprofils 50 sind außerdem an dem Randbereich Öffnungen 53, z. B. als Bohrungen ausgeführt, angebracht, die im in das Kastenprofil 40 eingeschobenen Zustand die Herstellung einer Schraubverbindung durch diese Öffnung 53 mit auf der Stirnseite 19 endenden Schraubkanälen 18a im Kastenprofil 40 ermöglichen. Das eingeschobene dritte Winkelprofil kann somit fest im Kastenprofil 40 fixiert werden.

Senkrecht vom zweiten Schenkel 52 des dritten Winkelprofils 50 abstehend, sind an diesem in seinen Endbereichen Griffrippen 54 angeordnet, die einen Griffbereich zur Verfügung stellen, der es ermöglicht, das dritte Winkelprofil 50 auch gegen die erwähnte Klemmkraft aus dem Kastenprofil 40 herauszuziehen.

Wie aus Figur 11 ersichtlich ist, können die in das Kastenprofil 40 eingeschobenen dritten Winkelprofile 50 mit ihren zweiten Schenkeln 52 derart aneinander grenzen, dass sie im Wesentlichen eine geschlossene stirnseitige Oberfläche oder zumindest einen Teil davon herstellen. Die dritten Winkelprofile 50 werden dabei mit ihren ersten Schenkeln 51 in die Schienen 26 des Kastenprofils 40 eingeschoben. Die Schienen verlaufen bevorzugt parallel zueinander, so dass die ersten Schenkel 51 im Wesentlichen planparallele Flächen und somit planparallele Unterteilungen des Kastenprofilvolumens erzeugen. Die dritten Winkelprofile 50 sind dabei bevorzugt von jeder Öffnungsseite des Kastenprofils 40 in dieses einschiebbar. Dabei können die Schienen 26 derart im Kastenprofil 40 angeordnet sein, dass jeweils zwei Schienen 26 unmittelbar nebeneinander angeordnet sind, so dass auch unmittelbar nebeneinander erste Schenkel 51 eingeschoben werden können. Die Abstände zwischen den Schienen 26 und den Einschraubkanälen 18a sind dabei jedoch so gewählt, dass zu jedem Schienenpaar 26 ein Einschraubkanal 18a zugeordnet ist, so dass jedes eingeschobene dritte Winkelprofil 50 mittels der Öffnungen 53 an den Einschraubkanälen 18a befestigt werden kann. Der Einschub der dritten Winkelprofile 50 in das Kastenprofil 40 kann dabei derart erfolgen, dass z. B. bei zwei der dritten Winkelprofile 50 die ersten Schenkel 51 unmittelbar bzw. dicht aneinander in benachbarte Schienen 26 eingeschoben sind, wobei die zweiten Schenkel 52 der beiden dritten Winkelprofile 50 an jeweils unterschiedlichen Seiten des Kastenprofils (vordere und hintere Stirnseite) angeordnet sind.

In Figur 12 ist ersichtlich, dass ein erfindungsgemäß hergestelltes erstes Kastenprofil 40 eine andere Breite haben kann als ein ebenfalls erfindungsgemäß hergestelltes zweites Kastenprofil 60. Am ersten Kastenprofil 40 können erste Befestigungselemente 61 angeordnet sein, welche komplementär ausgestaltet sind zu zweiten Befestigungselementen 62, die am zweiten Kastenprofil 60 angeordnet sind. Durch die kraft- und/oder formschlüssige Verbindung der ersten Befestigungselemente 61 mit den zweiten Befestigungselementen 62 lässt sich das erste Kastenprofil 40 mit dem zweiten Kastenprofil 60 wie in Figur 13 parallel zueinander verbinden. Es lässt sich somit das erfindungsgemäße System von Kastenprofilen zur Verfügung stellen.

In den die Breite definierenden Schenkeln der Kastenprofile 40, 60 sind Bohrungen 63 angeordnet, durch die Schraubverbindungen in Schraubkanäle 18a, wie sie in den Figuren 9 und 10 erkennbar sind, von oben bzw. von unten eingeschraubt werden können. Damit lässt sich das dritte Winkelprofil 50 fest mit der Innenwandung des Kastenprofils verbinden, so dass ein Wärmetransport vom dritten Winkelprofil 50 zum Kastenprofil und somit zu dessen Kühlrippen zwecks verbesserter Kühlwirkung realisierbar ist.

Das Winkelprofil oder das Kastenprofil kann gegebenenfalls mit Schnittstellen für einzusteckende Leiterplatten versehen sein.

Insbesondere in den kurzen Schenkeln der Winkelprofile können Durchführungen zur Aufnahme von Videokollektoren vorgesehen sein. Derartig ausgestaltete Winkelprofile oder Kastenprofile eignen sich insbesondere als Gehäuse für elektronische Bauteile in Fahrzeugen, wie zum Beispiel Bussen oder Bahnen.

Vorteilhafte Maße für das in den Figuren 1 bis 6 dargestellte kleinere Winkelprofil sind zum Beispiel eine Länge des kurzen Schenkels von 45 mm und eine Länge des längeren Schenkels von 170mm. Eine vorteilhafte Länge eines solchen Winkelprofils beträgt 100 mm oder ein ganzzahliges Vielfaches davon.

Die Länge des kurzen Schenkels von 45 mm stellt dabei eine Höheneinheit dar, nach der sich weitere Maße der unten beschriebenen Profile richten.

Die Gesamthöhe des Kastenprofils gemäß Figur 5 beträgt 2 Höheneinheiten und somit 90 mm. Die Höhe der Kastenprofile 40, 60 gemäß Figur 12 beträgt jeweils drei Höheneinheiten und somit 135 mm. Die Breite der zusammengefügten Kastenprofile 40, 60 gemäß Figur 13 beträgt 19 Zoll und somit zirka 483 mm. Alle Angaben sind dabei als theoretisch zu realisierende Maße zu verstehen, wobei die in der Praxis herstellbaren Maße den üblichen Fertigungstoleranzen unterliegen können.

Das heißt, dass die Länge des kurzen Schenkels der Winkelprofile gemäß der Figuren 1, 9 und 10 so ausgeführt ist, dass die Höhe des Kastenprofils gemäß Figur 2 eine Höheneinheit und somit 45 mm beträgt. Die Länge des kurzen Schenkels der Winkelprofile gemäß Figur 3 ist derart ausgeführt, dass die Höhe des Kastenprofils gemäß Figur 5 zwei Höheneinheiten und somit 90 mm nicht übersteigt.

Die Länge der langen Schenkel beider Winkelprofile ist derart, dass auf den Winkelprofilen Leiterplatten im Europakarten-Format montiert werden können. Für diesen Anwendungsfall sind die vorgenannten Profile auf eine Länge von 100 mm zu schneiden.

Die Länge des kurzen Schenkels der Winkelprofile gemäß der Figuren 7 und 8 ist derart, dass die Höhe des Kastenprofils gemäß Figur 12 drei Höheneinheiten und somit 135 mm nicht übersteigt.

Die Länge der langen Schenkel der Winkelprofile, aus denen die Kastenprofile gemäß Figur 12 aufgebaut werden, ist derart dimensioniert, dass die Gesamtbreite der kombinierten Kastenprofile gemäß Figur 13 19 Zoll und somit zirka 483 mm ergibt.

Vorteil der erfindungsgemäßen Winkelprofile beziehungsweise der daraus hergestellten Kastenprofile ist, dass sie aufgrund ihrer Herstellungsweise mittels Stranggussverfahren hinsichtlich ihrer Länge flexibel herstellbar sind. Das heißt, dass der Innenraum sowie die Anschluss- beziehungsweise Kühlfläche in einfacher Weise skalierbar ist. Die kleineren Winkelprofile, wie in den Figuren 1 bis 6 dargestellt, lassen sich (wie zum Beispiel in Figur 2 gezeigt) zu einem kleineren Kastenprofil miteinander verbinden oder aber auch, wie zum Beispiel in Figur 11 dargestellt, als stabiler und Wärme ableitender Träger für elektronische Leiterkarten verwenden, um diese als Einschub in Kastenprofile gemäß Figur 11 einzuführen.

Das heißt, dass die Winkelprofile flexibel einsetzbar sind, nämlich einerseits zur Herstellung von Kastenprofilen und andererseits zur Herstellung von Trennwänden in Kastenprofilen sowie zur Realisierung von zweiseitig offenen Kabelkanälen bei alleiniger Verwendung. Durch die vielfältigen Einsatzmöglichkeiten ergeben sich erhebliche Kosteneinsparpotenziale aufgrund der möglichen Massenfertigung im Stranggussverfahren.

Ein weiterer Vorteil des aus den Winkelprofilen hergestellten Kastenprofils ist, dass elektronische Bauelemente zunächst auf den Innenseiten eines ersten Winkelprofils angeordnet werden können und anschließend das Kastengehäuse durch Befestigung des zweiten Winkelprofils am ersten Winkelprofil geschlossen wird. Die Zugänglichkeit zu den Bauelementen ist dadurch wesentlich besser als bei aus dem Stand der Technik bekannten geschlossenen Profilen.

Vorteilhafterweise ist vorgesehen, dass die Innenseiten sowie die Teilkonturen beziehungsweise weitere Formelemente, die zur Verbindung von Schenkelenden der Winkelprofile dienen, für alle Winkelprofile identisch ausgeführt sind. Dadurch können sämtliche Leiterkarten oder sonstige Baugruppen bedarfsabhängig in allen zur Verfügung stehenden Winkelprofilarten eingesetzt werden. Daneben können alle unterschiedlichen Winkelprofile wahlweise zu unterschiedlichen Gehäusen kombiniert werden.

### Bezugszeichenliste

- 10: erstes Winkelprofil
- 11: erster Schenkel
- 12: zweiter Schenkel
- 13: Winkel
- 14: erste Kühlrippe
- 15: zweite Kühlrippe
- 16: erstes Formelement
- 17: zweites Formelement
- 18: Nutenschiene
- 18a: Schraubkanal
- 19: Stirnseite
- 20: Anbauteil, Hutschiene
- 21: Kabelkanal
- 22: Bohrung
- 23: Abdeckplatte
- 24: Öffnung
- 25: dritte Kühlrippe
- 26: Führungsschiene
- 30: zweites Winkelprofil
- 40: erstes Kastenprofil
- 41: vom Kastenprofil umschlossener Raum
- 42: Einzelraum
- 43: Stirnwand
- 50: drittes Winkelprofil
- 51: erster Schenkel des dritten Winkelprofils
- 52: zweiter Schenkel des dritten Winkelprofils
- 53: Öffnung
- 54: Griffrippe
- 60: zweites Kastenprofil
- 61: erstes Befestigungselement
- 62: zweites Befestigungselement
- 63: Loch

## Patentansprüche

1. Kastenprofil (40) für die Aufnahme von als Einschub eingeführten Leiterkarten, welches ein erstes und ein hinsichtlich der Schenkellängen und Winkel gleiches zweites Winkelprofil (10, 30) mit zwei Schenkeln umfasst, wobei wenigstens an einem Schenkel eine Mehrzahl von parallel zueinander verlaufenden Kühlrippen angeordnet sind, und wenigstens eine erste (14) und eine zweite Kühlrippe (15) jeweils ein erstes Formelement (16) aufweist, wobei die beiden ersten Formelemente (16) derart ausgestaltet sind, dass mit ihnen eine formschlüssig wirkende Arretierung wenigstens eines Anbauteiles (20) in wenigstens zwei translatorischen Freiheitsgraden auf den Kühlrippen (14, 15) realisierbar ist, und wobei das zweite Winkelprofil (30) in einer in Bezug zur Position des ersten Winkelprofils (10) um 180° gedrehten Lage mit beiden Schenkelenden mit den Schenkelenden des ersten Winkelprofils (10) zu einem in sich geschlossenem Kastenprofil mechanisch verbunden ist, und wobei das Kastenprofil weiterhin wenigstens ein in das Kastenprofil (40) eingeschobenes drittes Winkelprofil (50) umfasst, wobei die Länge des ersten Schenkels (51) des dritten Winkelprofils (50) im Wesentlichen der Länge des Kastenprofils (40) entspricht und die Breite des dritten Winkelprofils (50) der Höhe des Kastenprofils (40) entspricht und damit der erste Schenkel (51) des dritten Winkelprofils den vom Kastenprofil (40) umschlossenen Raum in zwei Einzelräume unterteilt, wobei der zweite Schenkel (52) des dritten Winkelprofils (50) zumindest einen Teil einer Stirnwand für das Kastenprofil ausbildet.

2. System aus wenigstens zwei miteinander mechanisch verbundenen Kastenprofilen gemäß Anspruche 1, wobei an einem ersten Kastenprofil (40) erste Befestigungselemente (61) angeordnet sind, mittels derer das erste Kastenprofil (40) an komplementär ausgebildeten zweiten Befestigungselementen (62) am zweiten Kastenprofil (60) fixiert ist.

## Claims

1. A box profile (40) for receiving printed circuit boards which are introduced as a subassembly, said box profile comprising a first and a second angle profile (10, 30) with two legs, the second angle profile being identical with respect to the leg lengths and angles, wherein a plurality of cooling ribs extending parallel to one another are arranged on at least one leg, and at least one first (14) and one second cooling rib (15) each have a first moulded element (16), wherein the two first moulded elements (16) are configured such that it is possible to produce with them a positively acting locking of at least one attachment part (20) in at least two translatory degrees of freedom on the cooling ribs (14, 15), and wherein the second angle profile (30) in a position rotated by 180° with respect to the position of the first angle profile (10) is mechanically connected by both ends of the legs to the ends of the legs of the first angle profile (10) to form a closed box profile, and wherein the box profile furthermore comprises at least one third angle profile (50) inserted into the box profile (40), wherein the length of the first leg (51) of the third angle profile (50) substantially corresponds to the length of the box profile (40) and the width of the third angle profile (50) corresponds to the height of the box profile (40) and therefore the first leg (51) of the third angle profile divides the space enclosed by the box profile (40) into two individual spaces, wherein the second leg (52) of the third angle profile (50) configures at least one part of a front wall for the box profile.

2. A system consisting of at least two box profiles which are mechanically connected to one another according to claim 1, wherein first fixing elements (61) are arranged on a first box profile (40), by means of which fixing elements the first box profile (40) is fixed to complementarily configured second fixing elements (62) on the second box profile (60).

## Revendications

1. Profilé en caisson (40) destiné à loger des cartes de circuit imprimé introduites en tant que pièces d'insertion, qui comprend un premier et un deuxième profilé d'angle (10, 30), identique quant aux longueurs de branches et aux angles, avec deux branches, une pluralité d'ailettes de refroidissement parallèles entre elles étant disposées au moins sur une banche, et au moins une première (14) et une deuxième ailette de refroidissement (15) présentant respectivement un premier élément de forme (16), les deux premiers éléments de forme (16) étant constitués de telle sorte que, avec eux, un blocage, agissant par liaison de forme, d'au moins une première pièce de montage (20) peut être réalisé dans au moins deux degrés de liberté de translation sur les ailettes de refroidissement (14, 15), et le deuxième profilé d'angle (30) étant raccordé mécaniquement aux extrémités de branche du premier profilé d'angle (10) dans une position tournée de 180° par rapport à la position du premier profilé d'angle (10) avec les deux extrémités de branche pour donner un profilé en caisson fermé sur lui-même, et le profilé en caisson comprenant également au moins un troisième profilé d'angle (50) inséré dans le profilé en caisson (40), la longueur de la première branche (51) du troisième profilé d'angle (50) correspondant essentiellement à la longueur du profilé en caisson (40), et la largeur du troisième profilé d'angle (50) correspondant à la hauteur du profilé en caisson (40), et ainsi la première branche (51) du troisième profilé d'angle divise en deux espaces individuels l'espace entouré par le profilé en caisson (40), la deuxième branche (52) du troisième profilé d'angle (50) constituant au moins une partie d'une paroi frontale pour le profilé en caisson.

2. Système composé d'au moins deux profilés en caisson raccordés mécaniquement l'un à l'autre selon la revendication 1, des premiers éléments de fixation (61) étant disposés sur un premier profilé en caisson (40), au moyen desquels le premier profilé en caisson (40) est fixé à des deuxièmes éléments de fixation (62) constitués de façon complémentaire sur le deuxième profilé en caisson (60).
